# EUROPÄISCHE PATENTSCHRIFT

(11) **EP 1 783 710 B1**
(45) Veröffentlichungstag und Bekanntmachung des Hinweises auf die Patenterteilung: **09.12.2015**
(21) Anmeldenummer: 06013928.4
(22) Anmeldetag: 05.07.2006
(51) Int. Cl.: G08B 13/12, G08B 25/14, H05K 5/00

(54) **Anzeige- und/oder Bedieneinheit für ein Überwachungssystem**
Display and/or operating unit for a surveillance system
Elément d'affichage et/ou de commande pour système de surveillance

(30) Priorität: 26.10.2005 DE 102005051253
(43) Veröffentlichungstag der Anmeldung: 09.05.2007
(73) Patentinhaber: primion Technology AG, 72510 Stetten a.k.M. (DE)
(72) Erfinder: Roth, Heinz, 78351 Ludwigshafen/Bodensee (DE)
(74) Vertreter: Daub, Thomas

(56) Entgegenhaltungen:
- WO-A1-93/22752
- DE-B3- 10 340 762
- GB-A- 2 317 491
- US-A- 5 633 623

## Beschreibung

### Stand der Technik

Die Erfindung geht aus von einer Anzeige- und/oder Bedieneinheit für ein Überwachungssystem nach dem Oberbegriff des Anspruchs 1.

Aus der WO 93/22752 A1 ist eine Anzeige- und/oder Bedieneinheit für ein Alarmsystem bekannt.

DE 103 40 762 B3 beschreibt eine Türstation.

Zudem sind bereits Anzeige- und Bedieneinheiten eines Zeiterfassungssystems bekannt, die eine lichtundurchlässige Gehäuseeinheit aufweist, wobei an einer Deckseite der Gehäuseeinheit eine Ausnehmung vorgesehen ist, über die Licht zur Ausgabe von Prozessinformationen ausgebbar ist.

### Vorteile der Erfindung

Die Erfindung geht aus von einer Anzeige- und/oder Bedieneinheit für ein Überwachungssystem, insbesondere für ein Zutritts-, Zeiterfassungs- und/oder Alarmsystem, mit einer Gehäuseeinheit, die wenigstens ein Gehäuseelement umfasst.

Der Erfindung liegt insbesondere die Aufgabe zugrunde, eine Sichtbarkeit und somit eine Bedienfreundlichkeit der Anzeige- und/oder Bedieneinheit zu erhöhen.

Erfindungsgemäß wird ein Zutritts- und/oder Zeiterfassungssystem, das eine für ein Überwachungssystem vorgesehene Anzeige- und/oder Bedieneinheit mit einer Gehäuseeinheit aufweist, die wenigstens ein Gehäuseelement umfasst, vorgeschlagen, wobei das Gehäuseelement zumindest teilweise aus einem lichtdurchlässigen Material gebildet ist. Unter einem "Gehäuseelement" soll insbesondere ein "tragendes Element" der Gehäuseeinheit verstanden werden. Ferner sollen unter einem "Gehäuseelement" insbesondere auch Bauteile verstanden werden, die eine Flächenabmessung größer als 6 cm², besonders vorteilhaft größer als 9 cm² und bevorzugt größer als 15 cm², aufweisen und/oder vorzugsweise mehrere Seiten der Gehäuseeinheit bilden. Unter "Licht" soll in diesem Zusammenhang insbesondere sichtbares Licht und unter "lichtdurchlässig" soll in diesem Zusammenhang insbesondere eine Durchlässigkeit, die größer ist als 10% und bevorzugt größer als 30% und besonders bevorzugt größer als 50%, verstanden werden.

Durch eine entsprechende erfindungsgemäße Ausgestaltung kann eine besonders gute Sichtbarkeit der Anzeige- und/oder Bedieneinheit über eine große Entfernung erreicht werden, und zwar insbesondere, indem große Licht abstrahlende Flächen sowie gewünschte Streuwirkungen einfach erzielt werden können, und besonders bevorzugt, wenn die Gehäuseeinheit zumindest an ihrer Vorderseite weitgehend, d.h. mehr als 50%, aus einem lichtdurchlässigen Material gebildet ist. Dabei soll unter einer "Vorderseite" insbesondere eine bei einem Standardbedienvorgang einem Bediener zugewandte Seite der Anzeige- und/oder Bedieneinheit verstanden werden.

Bei einem Gehäuseelement, das zumindest zwei, vorzugsweise zumindest drei Seiten einer das Gehäuseelement umfassenden Gehäuseeinheit bildet, kann ein Lichtsignal vorteilhaft mit einem großen Abstrahlungswinkel abgestrahlt werden. Unter einem "großen Abstrahlungswinkel" soll insbesondere ein Abstrahlungswinkel verstanden werden, der vorteilhaft größer als 2 π Steradiant ist.

In einer weiteren Ausgestaltung der Erfindung wird vorgeschlagen, dass die Gehäuseeinheit zumindest teilweise, vorzugsweise weitgehend, aus Glas hergestellt ist, wodurch eine besonders vorteilhafte Lichtabstrahlung über die Gehäuseeinheit erzielt werden kann.

Grundsätzlich sind dabei verschiedene, dem Fachmann als sinnvoll erscheinende Glasarten denkbar, besonders vorteilhaft ist die Gehäuseeinheit jedoch aus einem Silikatglas hergestellt, wodurch diese einfach und kostengünstig besonders kratzbeständig, temperaturbeständig und chemikalienbeständig ausgeführt werden kann.

Ferner wird vorgeschlagen, dass die Gehäuseeinheit speziell ausgebildete Lichtbrechungsmittel aufweist, wodurch eine vorteilhaft zumindest weitgehend gleichmäßige Ausleuchtung der Gehäuseeinheit mit wenigen Leuchtmitteln einfach erreicht werden kann. Die Lichtbrechungsmittel, die speziell zur Brechung des Lichts vorgesehen sind, können von zusätzlichen Bauteilen gebildet und/oder können vorteilhaft angeformt sein, wie beispielsweise mittels eines Lasers an einer Oberfläche und/oder im Inneren des Materials und/oder vorzugsweise mittels eines Sand- oder Kugelstrahlers an der Oberfläche. Die Oberfläche mit den Lichtbrechungsmitteln kann dabei an einer Außenseite der Gehäuseeinheit und/oder vorteilhaft an einer Innenseite der Gehäuseeinheit angeordnet sein, wodurch eine schmutzunempfindliche, glatte Außenseite der Anzeige- und/oder Bedieneinheit sowie eine vorteilhafte Lichtbrechung erzielt werden kann.

Weist die Anzeige- und/oder Bedieneinheit eine Leuchteinheit auf, die dazu vorgesehen ist, durch die Gehäuseeinheit Licht abzustrahlen, kann deren Funktion vorteilhaft auf die Gehäuseeinheit abgestimmt werden. Dabei soll unter "vorgesehen" speziell ausgestattet und/oder ausgelegt verstanden werden.

In einer weiteren Ausgestaltung der Erfindung wird vorgeschlagen, dass die Anzeige- und/oder Bedieneinheit eine Einstelleinheit umfasst, mittels der ein von der Leuchteinheit abstrahlbares Licht einstellbar ist. Dabei können verschiedene, dem Fachmann als sinnvoll erscheinende Parameter einstellbar ausgeführt sein, wie beispielsweise Intensität bzw. Lichtstärke, Farbe bzw. Wellenlänge, Abstrahlrichtung usw. Mittels einer entsprechenden Ausgestaltung kann eine hohe Flexibilität erzielt und insbesondere kann die Herstellung von verschiedenfarbigen Gehäuseeinheiten vermieden, die Variantenvielfalt kann reduziert und es können Produktionskosten eingespart werden. Ferner kann mittels der Einstelleinheit eine komfortable Bedienung, insbesondere auch bei einem Endabnehmer, erreicht werden. Vorteilhaft kann erreicht werden, dass ein Endabnehmer ein abgestrahltes Licht auf seine Bedürfnisse und Wünsche anpassen kann.

Die Eingabeeinheit kann verschiedene, dem Fachmann als sinnvoll erscheinende Mittel umfassen, wie eine Recheneinheit, Eingabemittel, beispielsweise Dreh- und/oder Drückschalter, Berührfelder und/oder vorzugsweise auch akustische Eingabemittel usw.

In einer weiteren Ausgestaltung wird vorgeschlagen, dass die Anzeige- und/oder Bedieneinheit eine Einheit umfasst, die dazu vorgesehen ist, eine automatische Einstellung des von der Leuchteinheit abstrahlbaren Lichts abhängig von wenigstens einem Parameter in wenigstens einem Betriebsmodus vorzunehmen. Es kann eine vorteilhafte Anpassung an zumindest im Wesentlichen gleich bleibende Umgebungsbedingungen, wie beispielsweise an eine farbliche Umgebung, und/oder an sich verändernde Umgebungsbedingungen, wie Umgebungslichtverhältnisse, erreicht und/oder es kann, sollte die Einheit einen Bewegungssensor umfassen, vorteilhaft eine optische Änderung der Anzeige- und/oder Bedieneinheit erzielt werden, wenn sich eine Person der Anzeige- und/oder Bedieneinheit nähert.

Weist die Anzeige- und/oder Bedieneinheit zumindest eine Einheit auf, die dazu vorgesehen ist, über die Leuchteinheit Informationen auszugeben, kann eine vorteilhafte Informationsübertragung, insbesondere über größere Distanzen, einfach erzielt werden. Dabei können verschiedene, dem Fachmann als sinnvoll erscheinende Informationen ausgegeben werden, wie insbesondere Informationen über einen vorliegenden Betriebsmodus, beispielsweise kann in einem Alarmmodus die Farbe, die Intensität bzw. Lichtstärke, eine Lichtabstrahldauer, eine Blinkfrequenz und/oder eine Abstrahlrichtung usw. gegenüber einem Standardmodus verändert werden, um den Alarmmodus entsprechend zu kennzeichnen. Es können einem Bediener Informationen zur Betriebsbereitschaft, über vorliegende Defekte, Informationen zu erforderlichen Eingaben und/oder bereits getätigten Eingaben übermittelt werden, beispielsweise kann einem Bediener signalisiert werden, ob die von ihm getätigten Eingaben korrekt oder inkorrekt waren.

Ferner wird vorgeschlagen, dass die Leuchteinheit dazu vorgesehen ist, Licht zumindest teilweise in eine einer Vorderseite abgewandte Richtung abzustrahlen, wodurch eine zur Befestigung genutzte Wand vorteilhaft für optische Funktionen genutzt werden kann, wie beispielsweise zur Informationsübertragung usw.

Ist die Leuchteinheit dazu vorgesehen, Licht durch einen Teilbereich der Gehäuseeinheit zur Abhebung des Teilbereichs bzw. zur Kennzeichnung desselben abzustrahlen, können vorteilhaft ein oder mehrere Teilbereiche konstruktiv einfach hervorgehoben werden, wodurch insbesondere der Bedienkomfort gesteigert und Bedienfehler vermieden werden können, beispielsweise indem einem Bediener durch Hervorheben eines Bereichs eine Position einer Leseeinheit angezeigt wird.

In einer weiteren Ausgestaltung der Erfindung wird vorgeschlagen, dass die Anzeige- und/oder Bedieneinheit ein Display bzw. einen Flachbildschirm aufweist, der zumindest teilweise einstückig mit der Leuchteinheit ausgebildet ist. Es können zusätzliche Bauteile, Bauraum, Gewicht, Montageaufwand und Kosten eingespart werden. Ferner kann konstruktiv einfach und kostengünstig eine hohe Flexibilität insbesondere im Hinblick auf die Farbe des abzustrahlenden Lichts erreicht werden. Die Leuchteinheit kann jedoch auch andere, dem Fachmann als sinnvoll erscheinende Leuchtmittel umfassen, wie Leuchtfolien, Leuchtdioden usw.

Weist die Gehäuseeinheit wenigstens eine auf einer Innenseite der Gehäuseeinheit angeordnete Sensoreinheit auf, kann konstruktiv einfach ein weiteres Funktionselement in die Gehäuseeinheit integriert werden. Die Anordnung an der Innenseite schützt den Sensor vor Beschädigungen und Verschmutzungen. Weiterhin kann eine schmutzunempfindliche, glatte Außenseite der Anzeige- und/oder Bedieneinheit erreicht werden.

In einer weiteren Ausgestaltung der Erfindung wird vorgeschlagen, dass die Sensoreinheit eine Eingabeeinheit bildet, wodurch bei einer Anordnung auf der Innenseite der Gehäuseeinheit besonders sensible Bereiche der Sensoreinheit vorteilhaft vor beispielsweise berührungsvermittelten Verschmutzungen oder unsachgemäßer Behandlung geschützt werden können. Weiterhin kann eine lange Lebensdauer der Eingabeeinheit erreicht werden. Ferner kann durch eine vorteilhafte örtliche Zuordnung der Eingabeeinheit im Bezug auf die Einheit, die über die Leuchteinheit Informationen ausgeben kann, eine Kombination einer Eingabequalität mit der Ausgabe von Informationen in Form von beispielsweise farbigen Lichtsignalen erzielt werden. Die Eingabeeinheit kann ein Eingabemittel, beispielsweise in Form einer Tastatur, oder ein Abrastermittel, beispielsweise in Form eines Fingerabdruck- oder eines Netzhautscanners, und/oder ein anderes, dem Fachmann als sinnvoll erscheinendes Mittel sein.

Als besonders vorteilhaft kann angesehen werden, dass eine Leuchteinheit zur Beleuchtung eines Bereichs der Sensoreinheit vorgesehen ist. Dadurch kann konstruktiv einfach und kostengünstig eine Beleuchtung der Sensoreinheit erreicht werden, die zusätzlich eine Beurteilung eines detektierten Signals der Sensoreinheit durch beispielsweise einen Farbwechsel vermitteln kann. Wird beispielsweise von einem Nutzer ein falscher Zutrittscode eingegeben, könnte die Beleuchtung von grün nach rot wechseln. Weiterhin kann sich daraus ein Beleuchtungsmodus der Sensoreinheit abhängig vom Betriebszustand der Anzeige- und/oder Bedieneinheit ergeben. Ferner kann vorteilhaft in verschiedenen Modi die Sensoreinheit gezielt für einen Bediener unkenntlich im Hintergrund gehalten werden, wie beispielsweise im Ruhezustand oder im Alarmmodus.

Ferner wird vorgeschlagen, dass wenigstens ein Sensormittel der Sensoreinheit von einem kapazitiven Mittel gebildet ist, wodurch die Größe, der Montageaufwand und der Energieverbrauch der Sensoreinheit vorteilhaft und kostengünstig realisiert werden können. Weiterhin kann somit sowohl eine berührungslose als auch eine berührungsvermittelte Aktivierung des Sensors erreicht werden, was die Flexibilität in der Auswahl der Sensoreinheit erhöht. Es wäre auch die Bildung der Sensoreinheit als optisches Mittel oder als ein anderes, dem Fachmann als sinnvoll erscheinendes Mittel denkbar.

Ist zumindest ein Bestandteil der Sensoreinheit auf einer Innenseite der Gehäuseeinheit aufgedruckt, kann eine leichte, schnelle und kostengünstige Montierbarkeit erreicht werden. Weiterhin ist die maschinelle Serienproduktion einfach und mit wenig Ausschuss realisierbar. Zusätzlich oder alternativ können jedoch auch zumindest einzelne Bestandteile der Sensoreinheit als eigenes Bauteil ausgestaltet sein, die beispielsweise an die Innenseite der Gehäuseeinheit aufgeklebt werden können.

Die Erfindung eignet sich besonders für Anzeige- und/oder Bedieneinheiten für Zutritts-, Zeiterfassungs- und/oder Alarmsysteme, jedoch auch für Gebäudeleitsysteme usw. Zeichnung

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine Anzeige- und Bedieneinheit für ein Zeiterfassungssystem schräg von der Seite,
- Fig. 2: die Anzeige- und Bedieneinheit aus Figur 1 in einer Seitenansicht und
- Fig. 3: einen vergrößerten Ausschnitt III aus Figur 2.

### Beschreibung des Ausführungsbeispiels

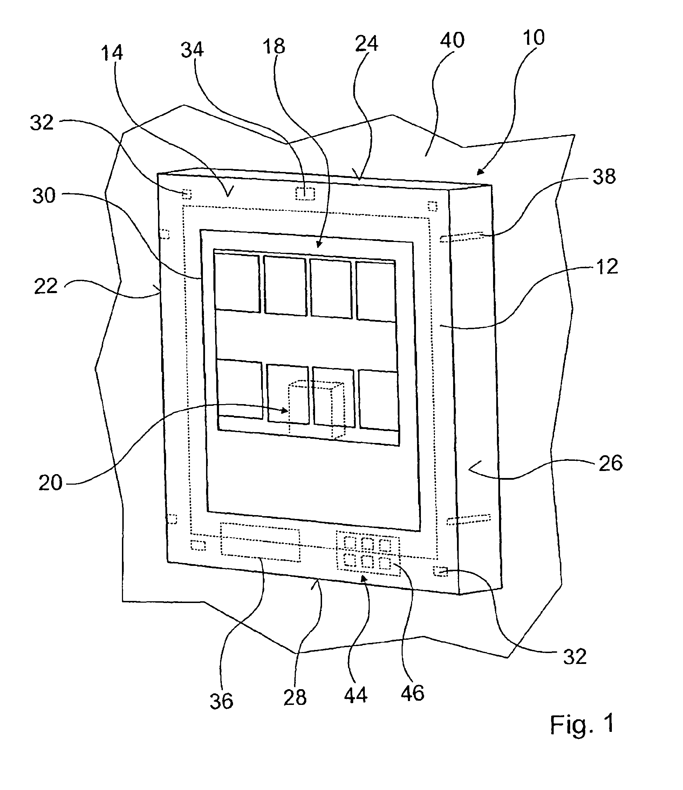

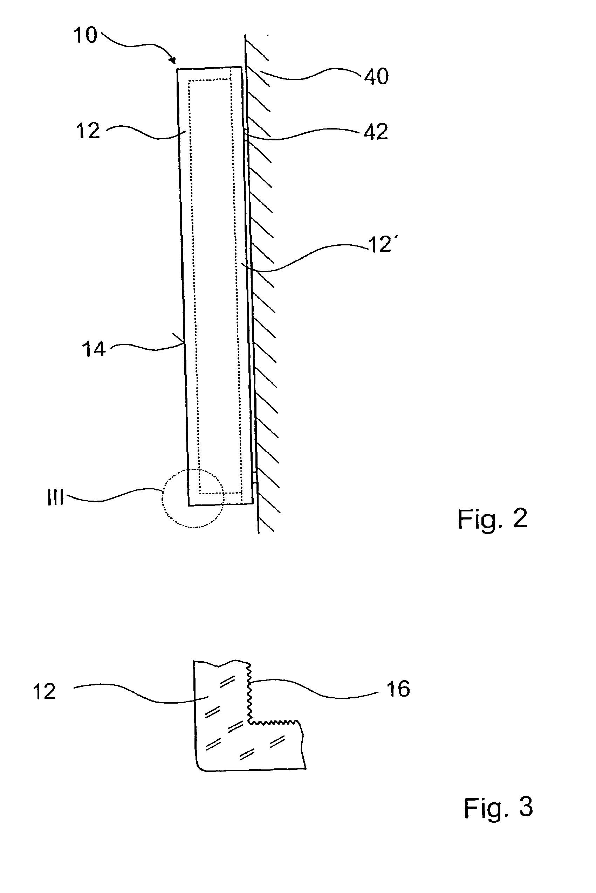

Figur 1 zeigt eine Anzeige- und Bedieneinheit für ein Zeiterfassungssystem bzw. ein Zeiterfassungsterminal mit einer quaderförmigen Gehäuseeinheit 10, die ein eine Vorderseite 14 und Seitenflächen 22, 24, 26, 28 bildendes Gehäuseelement 12 umfasst, das aus einem lichtdurchlässigen Silikatglas hergestellt ist. Das Gehäuseelement 12 ist an seiner Innenseite sandgestrahlt und weist dadurch bedingt von Vertiefungen und Erhebungen gebildete Lichtbrechungsmittel 16 auf. Alternativ oder zusätzlich könnte das Gehäuseelement 12 jedoch auch auf seiner Außenseite sandgestrahlt ausgeführt sein. Ferner umfasst die Gehäuseeinheit 10 ein eine Rückwand bildendes Gehäuseelement 12' aus einem lichtdurchlässigen Silikatglas, das ebenfalls auf seiner Innenseite sandgestrahlt ist (Figur 2).

In der Gehäuseeinheit 10 ist ein Touchscreen bzw. ein berührempfindliches Display angeordnet, das über eine rechteckige Ausnehmung 30 an der Vorderseite 14 des Gehäuseelements 12 einsehbar und bedienbar ist. Das Display erstreckt sich innerhalb der Gehäuseeinheit 10 seitlich über die Ausnehmung 30 hinaus und bildet im Wesentlichen eine Leuchteinheit 18, die dazu vorgesehen ist, durch die Gehäuseeinheit 10 Licht nach außen abzustrahlen. Alternativ oder zusätzlich könnten auch von dem Display ein oder mehrere getrennte Lichtquellen 32 vorgesehen sein, die beispielsweise von Leuchtdioden, Leuchtfolien usw. gebildet sein könnten, wie dies in Figur 1 angedeutet ist.

Die Anzeige- und Bedieneinheit umfasst eine Einheit 20, die insbesondere eine Recheneinheit und eine Speichereinheit umfasst und ein Teil einer Einstelleinheit bildet, mittels der über das Display bzw. den Touchscreen ein von der Leuchteinheit 18 über bzw. durch die Gehäuseeinheit 10 abstrahlbares Licht einstellbar ist. Insbesondere kann von einem Bediener die Farbe eines sich über die Ausnehmung 30 hinaus erstreckenden Seitenrands des Displays in einem Grundmodus eingestellt werden, so dass die Anzeige- und Bedieneinheit farblich an seine Umgebung vorteilhaft angepasst werden kann. Durch die Sandstrahlung kann dabei eine vorteilhaft gleichmäßige Ausleuchtung der Gehäuseeinheit 10 erreicht werden. Ferner dient die Einheit 20 dazu, abhängig von verschiedenen Parametern eine automatische Einstellung des von der Leuchteinheit 18 über bzw. durch die Gehäuseeinheit 10 abgestrahlten Lichts einzustellen und Informationen auszugeben. Wird eine Zeitbuchung angenommen, wird grünes Licht über die Gehäuseeinheit 10 abgestrahlt, liegt ein Fehler vor, wird rotes Licht über die Gehäuseeinheit 10 abgestrahlt. Wird über einen Bewegungsmelder 34 der Anzeige- und Bedieneinheit eine Annäherung eines Bedieners erfasst, wird mittels der Leuchteinheit 18 Licht durch einen Teilbereich 36 der Gehäuseeinheit 10 zur Abhebung bzw. Kennzeichnung des Teilbereichs 36 und zur Kennzeichnung einer Position einer Leseeinheit abgestrahlt. Ferner wird über die Einheit 20 die Lichtintensität abhängig von der Umgebungshelligkeit eingestellt, und zwar wird insbesondere bei dunklerer Umgebung, beispielsweise in einem unbeleuchteten Raum bei Nacht, die Lichtintensität reduziert und bei hellerer Umgebung, beispielsweise in einem Raum mit vielen Fenstern an einem sonnigen Tag, erhöht.

Die Leuchteinheit 18 weist zudem Lichtleitmittel 38 auf, mittels denen Licht von dem Display in eine der Vorderseite 14 abgewandte Richtung umgelenkt wird, um das Licht über das die Rückwand bildende Gehäuseelement 12' abzustrahlen und eine zur Befestigung der Anzeige vorgesehene Wand 40 auszuleuchten. Alternativ oder zusätzlich zu Lichtleitmitteln 38 könnte die Leuchteinheit 18 auch zum Display separat ausgebildete Leuchtmittel aufweisen, die zur Abstrahlung von Licht in eine der Vorderseite 14 abgewandte Richtung vorgesehen sind. Um eine vorteilhafte Ausleuchtung der Wand 40 zu ermöglichen, weist die Anzeige- und Bedieneinheit fußartige Abstandsmittel 42 auf, so dass das Gehäuseelement 12' im montierten Zustand beabstandet zur Wand 40 angeordnet ist (Figur 2).

An der Innenseite der Gehäuseeinheit 10, auf der auch die Lichtbrechungsmittel 16 ausgebildet sind, befindet sich eine Sensoreinheit 44, die im unbeleuchteten Zustand unsichtbar ist. Die Gehäuseeinheit 10 ist zumindest an einer Befestigungsstelle aus Silikatglas gefertigt. An diese Befestigungsstelle ist die Sensoreinheit 44 angeordnet, bevorzugt angeklebt. Die Sensoreinheit 44 ist als Eingabeeinheit 46 in Form einer Tastatur ausgebildet. Es wäre jedoch auch eine Ausgestaltung als Abrastereinheit oder als ein, dem Fachmann als sinnvoll erscheinendes, weiteres Mittel denkbar. Die Beschriftung der Tastatur wird von hinten - auf der sandgestrahlten Seite des Silikatglases - auf die Silikatglasscheibe gedruckt und ist durch die Leuchteinheit 18 bestrahlbar, wodurch die Beschriftung, abhängig vom Aktivitätsstatus der Anzeige- und Bedieneinheit, unsichtbar, sichtbar und/oder farbig hervorgehoben wird.

**Bezugszeichen**

| | | | |
|---|---|---|---|
| 10 | Gehäuseeinheit | 42 | Abstandsmittel |
| 12 | Gehäuseelement | 44 | Sensoreinheit |
| 14 | Vorderseite | 46 | Eingabeeinheit |
| 16 | Lichtbrechungsmittel | | |
| 18 | Leuchteinheit | | |
| 20 | Einheit | | |
| 22 | Seitenfläche | | |
| 24 | Seitenfläche | | |
| 26 | Seitenfläche | | |
| 28 | Seitenfläche | | |
| 30 | Ausnehmung | | |
| 32 | Lichtquelle | | |
| 34 | Bewegungsmelder | | |
| 36 | Teilbereich | | |
| 38 | Lichtleitmittel | | |
| 40 | Wand | | |

## Patentansprüche

1. Zutritts- und/oder Zeiterfassungssystem, das eine für ein Überwachungssystem vorgesehene Anzeige- und/oder Bedieneinheit mit einer Gehäuseeinheit (10), die wenigstens ein Gehäuseelement (12) umfasst, aufweist, wobei das Gehäuseelement (12) zumindest teilweise aus einem lichtdurchlässigen Material gebildet ist und die Anzeige- und/oder Bedieneinheit wenigstens eine Leuchteinheit (18) aufweist, die dazu vorgesehen ist, durch die Gehäuseeinheit (10) Licht abzustrahlen,
**gekennzeichnet durch**
eine Einheit (20), die dazu vorgesehen ist, über die Leuchteinheit (18) Informationen auszugeben.

2. Zutritts- und/oder Zeiterfassungssystem nach Anspruch 1,
**dadurch gekennzeichnet,**
**dass** die Gehäuseeinheit (10) zumindest an ihrer Vorderseite (14) weitgehend aus einem lichtdurchlässigen Material gebildet ist.

3. Zutritts- und/oder Zeiterfassungssystem nach Anspruch 1 oder 2,
**dadurch gekennzeichnet,**
**dass** die Gehäuseeinheit (10) zumindest teilweise aus Glas hergestellt ist.

4. Zutritts- und/oder Zeiterfassungssystem nach Anspruch 3,
**dadurch gekennzeichnet,**
**dass** die Gehäuseeinheit (10) aus einem Silikatglas hergestellt ist.

5. Zutritt- und/oder Zeiterfassungssystem nach einem der vorhergehenden Ansprüche,
**dadurch gekennzeichnet,**
**dass** die Gehäuseeinheit (10) speziell ausgebildete Lichtbrechungsmittel (16) aufweist.

6. Zutritts- und/oder Zeiterfassungssystem nach einem der vorhergehenden Ansprüche,
**dadurch gekennzeichnet,**
**dass** die Anzeige- und/oder Bedieneinheit eine Einstelleinheit aufweist, mittels der ein von der Leuchteinheit (18) abstrahlbares Licht einstellbar ist.

7. Zutritts- und/oder Zeiterfassungssystem nach einem der vorhergehenden Ansprüche,
**dadurch gekennzeichnet,**
**dass** die Anzeige- und/oder Bedieneinheit eine Einheit (20) aufweist, die dazu vorgesehen ist, eine automatische Einstellung des von der Leuchteinheit (18) abstrahlbaren Lichts abhängig von wenigstens einem Parameter in wenigstens einem Betriebsmodus vorzunehmen.

8. Zutritts- und/oder Zeiterfassungssystem nach einem der vorhergehenden Ansprüche,
**dadurch gekennzeichnet,**
**dass** die Leuchteinheit (18) dazu vorgesehen ist, Licht zumindest teilweise in eine einer Vorderseite (14) abgewandte Richtung abzustrahlen.

9. Zutritts- und/oder Zeiterfassungssystem nach einem der vorhergehenden Ansprüche,
**dadurch gekennzeichnet,**
**dass** die Leuchteinheit (18) dazu vorgesehen ist, Licht durch einen Teilbereich (36) der Gehäuseeinheit (10) zur Abhebung des Teilbereichs (36) abzustrahlen.

10. Zutritts- und/oder Zeiterfassungssystem nach einem der vorhergehenden Ansprüche,
**dadurch gekennzeichnet,**
**dass** die Anzeige- und/oder Bedieneinheit ein Display aufweist, das zumindest teilweise einstückig mit der Leuchteinheit (18) ausgebildet ist.

11. Zutritts- und/oder Zeiterfassungssystem nach einem der vorhergehenden Ansprüche,
**dadurch gekennzeichnet,**
**dass** die Anzeige- und/oder Bedieneinheit wenigstens eine auf einer Innenseite der Gehäuseeinheit (10) angeordnete Sensoreinheit (44) aufweist.

12. Zutritt- und/oder Zeiterfassungssystem nach Anspruch 11,
**dadurch gekennzeichnet,**
**dass** die Sensoreinheit (44) eine Eingabeeinheit (46) bildet.

13. Zutritts- und/oder Zeiterfassungssystem nach Anspruch 11 oder 12,
**dadurch gekennzeichnet,**
**dass** eine Leuchteinheit (18) zur Beleuchtung eines Bereichs der Sensoreinheit (44) vorgesehen ist.

14. Zutritts- und/oder Zeiterfassungssystem nach einem der Ansprüche 11 bis 13,
**dadurch gekennzeichnet,**
**dass** wenigstens ein Sensormittel der Sensoreinheit (44) von einem kapazitiven Mittel gebildet ist.

15. Zutritts- und/oder Zeiterfassungssystem nach einem der Ansprüche 11 bis 14,
**dadurch gekennzeichnet,**
**dass** zumindest ein Bestandteil der Sensoreinheit (44) auf einer Innenseite der Gehäuseeinheit (10) aufgedruckt ist.

16. Verfahren zur Verwendung eines Zutritts- und/oder Zeiterfassungssystems nach einem der vorhergehenden Ansprüche.

## Claims

1. Access capturing and/or time capturing system, comprising a display and/or operating unit with a housing unit (10) that comprises at least one housing element (12), the housing element (12) being implemented at least partially by a translucent material and the display and/or operating unit comprising at least one illuminating unit (18), which is provided to emit light through the housing unit (10),
**characterised by**
a unit (20) provided to output information via the illuminating unit (18).

2. Access capturing and/or time capturing system according to claim 1,
**characterised in that**
the housing unit (10) is implemented to a large part by a translucent material at least on its front face (14).

3. Access capturing and/or time capturing system according to claim 1 or 2,
**characterised in that**
the housing unit (10) is at least partially made of glass.

4. Access capturing and/or time capturing system according to claim 3,
**characterised in that**
the housing unit (10) is made of a silicate glass.

5. Access capturing and/or time capturing system according to one of the preceding claims,
**characterised in that**
the housing unit (10) comprises specifically implemented light refraction elements (16).

6. Access capturing and/or time capturing system according to one of the preceding claims,
**characterised in that**
the display and/or operating unit comprises an adjusting unit that allows adjustment of a light that is emittable by the illuminating unit (18).

7. Access capturing and/or time capturing system according to one of the preceding claims,
**characterised in that**
the display and/or operating unit comprises a unit (20), which is provided to execute in at least one operating mode an automatic adjustment of the light that is emittable by the illuminating unit (18) in dependence of at least one parameter.

8. Access capturing and/or time capturing system according to one of the preceding claims,
**characterised in that**
the illuminating unit (18) is provided to emit light at least partially in a direction facing away from a front face (14).

9. Access capturing and/or time capturing system according to one of the preceding claims,
**characterised in that**
the illuminating unit (18) is provided to emit light through a partial region (36) of the housing unit (10) for distinguishing the partial region (36).

10. Access capturing and/or time capturing system according to one of the preceding claims,
**characterised in that**
the display and/or operating unit comprises a display which is embodied at least partially in a one-part implementation with the illuminating unit (18).

11. Access capturing and/or time capturing system according to one of the preceding claims,
**characterised in that**
the display and/or operating unit comprises at least one sensor unit (44), which is arranged on an interior side of the housing unit (10).

12. Access capturing and/or time capturing system according to claim 11,
**characterised in that**
the sensor unit (44) forms an input unit (46).

13. Access capturing and/or time capturing system according to claim 11 or 12,
**characterised in that**
an illuminating unit (18) is provided for the illumination of a region of the sensor unit (44).

14. Access capturing and/or time capturing system according to one of the preceding claims,
**characterised in that**
at least one sensor element of the sensor unit (44) is implemented by a capacitive element.

15. Access capturing and/or time capturing system according to one of claims 11 to 14,
**characterised in that**
at least one component of the sensor unit (44) is printed on an interior side of the housing unit (10).

16. Method for the utilization of an access capturing and/or time capturing system according to one of the preceding claims.

## Revendications

1. Système de captage d'accès et/ou de temps, comprenant une unité d'affichage et/ou d'opération prévue à un système de surveillance, avec une unité de boîtier (10) laquelle présente au moins un élément de boîtier (12),
l'élément de boîtier (12) étant implémenté au moins partiellement d'un matériau translucide et l'unité d'affichage et/ou d'opération présentant au moins une unité d'illumination (18) laquelle est prévue à émettre de la lumière par l'unité de boîtier (10),
**caractérisé par**
une unité (20) prévue à rendre des informations par le biais de l'unité d'illumination (18).

2. Système de captage d'accès et/ou de temps selon la revendication 1,
**caractérisé en ce que**
l'unité de boîtier (10) est largement implémentée, au moins de son côté avant (14), d'un matériau translucide.

3. Système de captage d'accès et/ou de temps selon l'une quelconque des revendications 1 ou 2,
**caractérisé en ce que**
l'unité de boîtier (10) est au moins partiellement manufacturée de verre.

4. Système de captage d'accès et/ou de temps selon la revendication 3,
**caractérisé en ce que**
l'unité de boîtier (10) est manufacturée d'un verre de silicate.

5. Système de captage d'accès et/ou de temps selon l'une quelconque des revendications précédentes,
**caractérisé en ce que**
l'unité de boîtier (10) présente des moyens de réfraction optique (16) lesquels sont implémentés de manière spéciale.

6. Système de captage d'accès et/ou de temps selon l'une quelconque des revendications précédentes,
**caractérisé en ce que**
l'unité d'affichage et/ou d'opération comprend une unité d'ajustement, laquelle permet d'ajuster une lumière qui peut être émise par l'unité d'illumination (18).

7. Système de captage d'accès et/ou de temps selon l'une quelconque des revendications précédentes,
**caractérisé en ce que**
l'unité d'affichage et/ou d'opération comprend une unité (20), laquelle est prévue à effectuer, dans au moins un mode opératif, un ajustement automatique de la lumière qui peut être émise par le biais de l'unité d'illumination (18) en dépendance à au moins un paramètre.

8. Système de captage d'accès et/ou de temps selon l'une quelconque des revendications précédentes,
**caractérisé en ce que**
l'unité d'illumination (18) est prévue à émettre de lumière au moins partiellement dans une direction détournée d'un côté avant (14).

9. Système de captage d'accès et/ou de temps selon l'une quelconque des revendications précédentes,
**caractérisé en ce que**
l'unité d'illumination (18) est prévue à émettre de la lumière par une zone partielle (36) de l'unité de boîtier (10) pour distinguer la zone partielle (36).

10. Système de captage d'accès et/ou de temps selon l'une quelconque des revendications précédentes,
**caractérisé en ce que**
l'unité d'affichage et/ou d'opération comprend un affichage implémenté au moins partiellement d'une pièce avec l'unité d'illumination (18).

11. Système de captage d'accès et/ou de temps selon l'une quelconque des revendications précédentes,
**caractérisé en ce que**
l'unité d'affichage et/ou d'opération comprend au moins une unité de capteur (44) disposée d'un côté intérieur de l'unité de boîtier (10).

12. Système de captage d'accès et/ou de temps selon la revendication 11,
**caractérisé en ce que**
l'unité de capteur (44) implémente une unité de donnée (46).

13. Système de captage d'accès et/ou de temps selon l'une quelconque des revendications 11 ou 12,
**caractérisé en ce qu'**
une unité d'illumination (18) est prévue à illuminer une région de l'unité de capteur (44).

14. Système de captage d'accès et/ou de temps selon l'une quelconque des revendications 11 à 13,
**caractérisé en ce qu'**
au moins un moyen de capteur de l'unité de capteur (44) est implémenté par un moyen capacitif.

15. Système de captage d'accès et/ou de temps selon l'une quelconque des revendications 11 à 14,
**caractérisé en ce qu'**
un composant de l'unité de capteur (44) est imprimé sur un côté intérieur de l'unité de boîtier (10).

16. Méthode pour l'usage d'un système de captage d'accès et/ou de temps selon l'une quelconque des revendications précédentes.
